# EUROPÄISCHE PATENTANMELDUNG

(11) **EP 1 308 734 A2**
(43) Veröffentlichungstag der Anmeldung: **07.05.2003**
(21) Anmeldenummer: 02017194.8
(22) Anmeldetag: 31.07.2002
(51) Int. Cl.: G01R 31/30

(54) **Elektrische Schaltungsanordnung**

(30) Priorität: 20.10.2001 DE 10152256
(71) Anmelder: ROBERT BOSCH GMBH, 70442 Stuttgart (DE)
(72) Erfinder: Haeuser, Thomas, 71696 Moeglingen (DE); Hesselbarth, Johannes, 71696 Moeglingen (DE)

(57) **Zusammenfassung**

Elektrische Schaltungsanordnung zum Erkennen eines Kurzschlusses zwischen Ausgangs-PINs unterschiedlicher ICs, insbesondere CMOS-ICs, welche jeweils als Ausgangstreiber ein erstes Schaltmittel, insbesondere einen Highside-Transistor (Q_{H,1}, Q_{H,2}) und ein zweites Schaltmittel, insbesondere einen Lowside-Transistor (Q_{L,1}, Q_{L,2}) aufweisen, wobei das erste Schaltmittel (Q_{H,1}, Q_{H,2}) und das zweite Schaltmittel (Q_{L,1}, Q_{L,2}) der jeweiligen Ausgangstreiber unterschiedliche Source-Drain-Widerstände im eingeschalteten Zustand (R_{DSon}) aufweisen.

## Beschreibung

Die vorliegende Erfindung betrifft eine elektrische Schaltungsanordnung nach dem Oberbegriff des Patentanspruchs 1.

Aus der DE 197 21 366 A1 ist eine elektrische Schaltungsanordnung zur Überprüfung einer aus einem Schalter und einer Last bestehenden Serienschaltung mit einer ersten Schaltung, die mit dem Verbindungspunkt zwischen dem Schalter und der Last verbunden ist, und die zur Erkennung eines ersten Zustandes geeignet ist, wobei der erste Zustand einen Kurzschluß des Verbindungspunktes zur Versorgungsspannung darstellt, bekannt. Diese Schaltungsanordnung zeichnet sich dadurch aus, daß der ersten Schaltung eine zweite Schaltung parallel geschaltet ist, die mit dem Verbindungspunkt verbunden ist und die zur Erkennung eines zweiten oder eines dritten Zustands geeignet ist, wobei der zweite Zustand einen Kurzschluß des Verbindungspunkts nach Masse und der dritte Zustand eine Unterbrechung des Verbindungspunkts zur Versorgungsspannung darstellt.

Sicherheitsrelevante Systeme beispielsweise bei Kraftfahrzeugen dürfen auch im Fehlerfall nicht zu einem sicherheitskritischen Zustand führen. Im Zusammenhang mit derartigen Nachweisen wird üblicherweise eine sogenannte FMEA-Analyse (engl. Failure Mode and Effects Analysis) durchgeführt. Im Rahmen einer FMEA-Analyse werden typischerweise niedrige Stufen des Systems beschrieben. Bei diesen kann es sich um individuelle Komponenten oder um niederstufige Anordnungen handeln. Für jede derartige niedrige Stufe wird eine Liste möglicher fehlerhafter Betriebsarten erzeugt, wobei anschließend Auswirkungen der möglichen fehlerhaften Betriebsarten bestimmt werden.

Für elektronische Steuergeräte werden im Rahmen einer FMEA-Analyse unter anderem Kurzschlüsse zwischen zwei benachbarten Ausgangs-PINs einer integrierten Schaltung, im folgenden als IC bezeichnet, betrachtet.

Typische Schwierigkeiten im Rahmen einer FMEA-Analyse sind z. B., daß Kurzschlüsse zwischen benachbarten PINs bzw. Ausgangs-PINs von Ausgangstreibern nicht dazu führen dürfen, daß ein sicherheitskritischer Abschaltpfad funktionsunfähig wird. Ferner muß durch Zurücklesen eines kritischen Ausgangssignals gewährleistet werden können, daß ein Fehler in der Signalübertragung zwischen zwei ICs erkannt wird.

Bei üblichen Ausgangstreibern von CMOS-ICs weisen der versorgungsspannungsseitige Transistor, im folgenden als Highside-Transistor bezeichnet, und der masseseitige Transistor, im folgenden als Lowside-Transistor bezeichnet, bei eingeschaltetem Transistor (MOSFET) den gleichen Drain-Source-Widerstand R_{DSon} auf. Dies führt dazu, daß sich bei einem Kurzschluß zwischen zwei PINs benachbarter Ausgangstreiber ein undefinierter Zustand ergeben kann, wenn einer der Ausgänge auf logisch H, der andere auf logisch L geschaltet ist.

Aufgabe der Erfindung ist daher die Bereitstellung einer Schaltungsanordnung, bei welcher in möglichst einfacher Weise auf einen Kurzschluß zwischen den PINs benachbarter Ausgangstreiber eines CMOS-IC geschlossen werden kann.

Diese Aufgabe wird gelöst durch eine elektrische Schaltungsanordnung mit den Merkmalen des Patentanspruchs 1.

Erfindungsgemäß können PIN-zu-PIN-Kurzschlüsse durch die unterschiedliche Dimensionierung der jeweiligen Schaltmittel mit weniger Aufwand abgefangen werden, da sich unter allen denkbaren Bedingungen bezüglich Mustern, Temperaturen und Toleranzen reproduzierbar der gleiche gültige logische Pegel einstellt. Die erfindungsgemäße Lösung zeichnet sich dadurch aus, daß sie gegenüber herkömmlichen ICs, insbesondere CMOS-ICs keine zusätzlichen Bauteile benötigt. Es sei in diesem Zusammenhang darauf hingewiesen, daß die erfindungsgemäße Erkennung eines Kurzschlusses zwischen zwei PINs auch mittels eines Open-Drain-PIN-Treibers erzielt werden könnte. Derartige PIN-Treiber haben jedoch den Nachteil, daß ein Pull-Up-Widerstand als zusätzliches externes Bauelement benötigt wird. Zudem steigt die Verlustleistung, da im Falle eines L-Pegels permanent ein Strom durch den Pull-Up-Widerstand fließt.

Vorteilhafte Ausgestaltungen der erfindungsgemäßen Schaltungsanordnung sind Gegenstand der Unteransprüche.

Gemäß einer bevorzugten Ausführungsform der erfindungsgemäßen Schaltungsanordnung ist der wenigstens eine IC als CMOS-IC ausgebildet, welcher als Ausgangstreiber einen Highside-Transistor und einen Lowside-Transistor aufweist, wobei der Highside-Transistor und der Lowside-Transistor unterschiedliche Source-Drain-Widerstände im eingeschalteten Zustand aufweisen. Derartige Bauteile sind in einfacher Weise bereitstellbar und erweisen sich in der Praxis als robust und zuverlässig.

Es ist bevorzugt, daß die Drain-Source-Widerstände der Lowside-Transistoren jeweils kleiner als die Drain-Source-Widerstände der Highside-Transistoren ausgebildet sind. Durch diese Dimensionierung ist der L-Pegel als dominanter Pegel einstellbar, welcher dem abgeschalteten und damit im allgemeinen weniger kritischen Zustand einer Funktion entspricht. Hierbei erweist es sich als zweckmäßig, die Lowside-Transistoren als N-Kanal MOSFETs auszubilden, da diese leichter mit geringerem R_{DSon} zu realisieren sind als P-Kanal-MOSFETs.

Die Erfindung wird nun anhand der beigefügten Zeichnung weiter beschrieben. In dieser zeigt:
Figur 1 eine schematisch vereinfachte Darstellung einer bevorzugten Ausführungsform der erfindungsgemäßen Schaltungsanordnung, und
Figur 2 ein Schaubild zur Erläuterung einer bevorzugten Ausführungsform der Erfindung anhand eines konkreten Schaltungszustands.

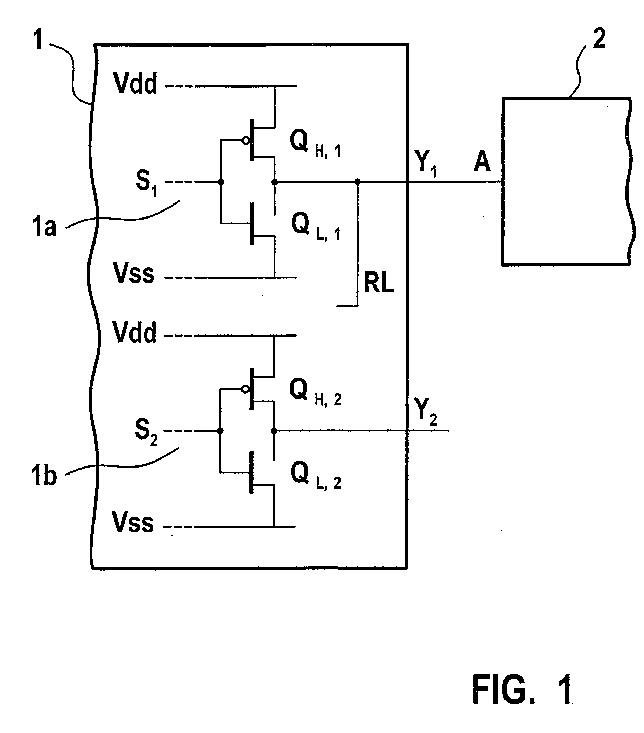

In der Figur 1 ist ein erster IC mit 1, ein zweiter IC mit 2 bezeichnet. Der erste IC 1 weist zwei Ausgangstreiber 1a, 1b auf. Die Ausgangstreiber 1a, 1b sind in CMOS-Technik ausgeführt, und weisen daher, wie an sich bekannt ist, jeweils einen Highside-Transistor Q_{H,1} bzw. Q_{H,2} bzw. einen Lowside-Transistor Q_{L,1} bzw. Q_{L,2} auf.

Die Eingangssignale der Ausgangstreiber 1a, 1b sind mit S₁ bzw. S₂ bezeichnet, ihre Ausgangssignale mit Y₁ bzw. Y₂ bezeichnet. Man erkennt, daß das Ausgangssignal Y₁ des ersten Ausgangstreibers als Eingangssignal A auf den zweiten IC gegeben wird. Es ist ferner ein Rücklesepfad RL vorgesehen, mittels dessen gewährleistet werden muß, daß ein Fehler in der Signalübertragung von Y₁ nach A erkannt wird. Die Versorgungsspannungspegel, an denen die Schaltungsanordnung anliegt, sind mit Vdd bzw. Vss bezeichnet. Es sei im folgenden der Einfachheit halber der Spannungspegel Vdd als Versorgungsspannung, und der Spannungspegel Vss als Masse bezeichnet. Kommt es zu einem (nicht dargestellten) Kurzschluß zwischen den zwei Ausgangs-PINs der Ausgangstreiber, d. h. zwischen den die Ausgangssignale Y₁ und Y₂ tragenden Leitungen, ergibt sich herkömmlicherweise ein undefinierter Zustand beispielsweise dann, wenn einer der Ausgänge auf logisch H, und der andere auf logisch L geschaltet war. Dies liegt darin begründet, daß die Highside-Transistoren und die Lowside-Transistoren der jeweiligen Ausgangstreiber 1a, 1b herkömmlicherweise mit gleichem Drain-Source-Widerstand R_{DSon} ausgelegt sind. Steht im dargestellten Beispiel beispielsweise der Ausgang Y₁ auf logisch H, und der Ausgang Y₂ auf logisch L, so stellt sich ein Ausgangspegel ein, der im wesentlichen durch den Spannungsteiler der Drain-Source-Widerstände von Q_{H,1} und Q_{L,2} gegeben ist. Dieser Pegel liegt typischerweise im nicht definierten Bereich zwischen H- und L-Pegel, kann aber je nach Fertigungstoleranzen, Temperaturen usw. auch einem gültigen H- oder L-Pegel entsprechen. Der von dem angeschlossenen Eingang A des zweiten IC 2 eingelesene Wert ist daher undefiniert.

Dies führt im dargestellten Beispiel zu folgenden Schwierigkeiten: Bei einem Kurzschluß zwischen Y₁ und Y₂ funktioniert der Abschaltpfad A nur in einem Teil der Muster. Untersuchungen an einem Muster lassen sich daher auf andere Muster bzw. Exemplare nicht übertragen.

Durch Rücklesen des Signals Y₁ in den IC1 (über Rücklesepfad RL) kann ein Fehler aufgrund eines Kurzschlusses zwischen Y₁ und Y₂ nicht sicher erkannt werden, da der Pegel im nicht definierten Bereich liegen kann. Bei einem Pegel im nicht definierten Bereich können der zurückgelesene logische Wert und der vom Eingang A eingelesene logische Wert unterschiedliche Werte annehmen.

Erfindungsgemäß ist nun vorgesehen, einen der Transistoren jedes Ausgangstreibers, bevorzugt den Lowside-Transistor Q_{L,1} bzw. Q_{L,2} entsprechend stärker, d. h. mit kleinerem Drain-Source-Widerstand R_{DSon} auszulegen. Dieser Transistor wird so dimensioniert (bzw. die jeweilige Highside- und Lowside-Transistoren so aufeinander abgestimmt), daß sich bei einem Kurzschluß zwischen zwei PINs mit unterschiedlichem Ausgangspegel definiert ein L-Pegel einstellt. Es sei darauf hingewiesen, daß bei komplexeren Ausgangsschaltungen die effektiven Widerstände der Transistoren entsprechend auszulegen sind.

PIN-PIN-Kurzschlüsse können bei Vorsehen dieser Maßnahme mit weniger Aufwand abgefangen werden, da sich für sämtliche Muster, Temperaturen und Toleranzen reproduzierbar der gleiche gültige logische Pegel einstellt. Der im dargestellten Beispiel eingestellte L-Pegel entspricht darüber hinaus dem abgeschalteten und damit im allgemeinen weniger kritischen Zustand einer Funktion eines Steuergeräts.

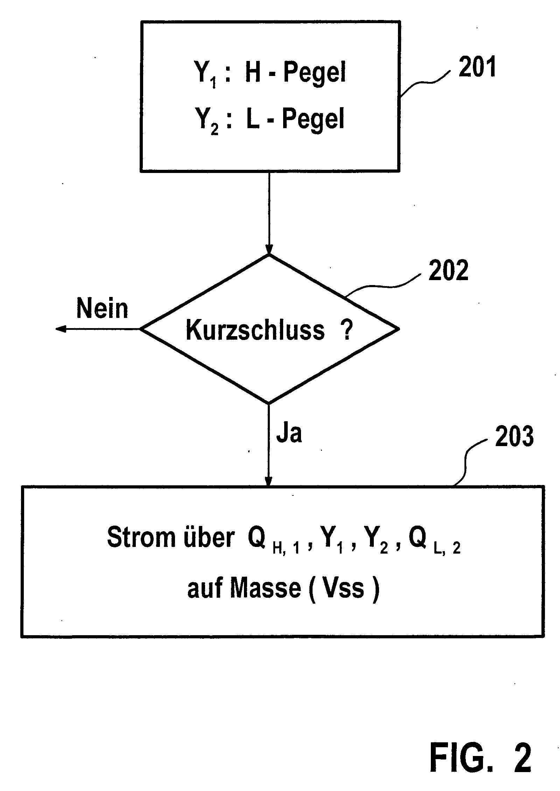

Die erfindungsgemäße Lösung soll unter Bezugnahme auf Figur 2 anhand eines konkreten Schaltzustandes weiter erläutert werden: Es sei davon ausgegangen, daß das Ausgangssignal Y₁ des ersten Ausgangstreibers 1a auf H-Pegel, das Ausgangssignal Y₂ des zweiten Ausgangstreibers ab auf L-Pegel liegt (Ausgangssituation 201). Für die Transistoren des ersten Ausgangstreibers bedeutet dies, daß der Highside-Transistor Q_{H,1} eingeschaltet, und der Lowside-Transitor Q_{L,1} gesperrt bzw. geschlossen ist. Im zweiten Ausgangstreiber 1b ist der Highside-Transistor Q_{H,2} gesperrt, während der Lowside-Transitor Q_{L,2} eingeschaltet ist. Im Falle eines Kurzschlusses (Ereignis 202) ergibt sich insgesamt ein Strom von Q_{H,1} über Y₁ über Y₂ über Q_{L,2} auf Masse (Vss) (Zustand 203). Durch entsprechend kleinere Dimensionierung des Drain-Source-Widerstandes R_{DSon} des Transistors Q_{L,2} bezüglich des Drain-Source-Widerstandes des Transistors Q_{H,1} läßt sich der resultierende Spannungspegel in die Nähe von Masse bzw. des Spannungspegels Vss drücken.

Dieser Zustand ist als fehlerhaft erkennbar, da die Signalpegel Y₁ und A über den Rücklesepfad RL als voneinander abweichend erkannt werden können. Insgesamt ist darauf hinzuweisen, daß bei einem Kurzschluß zwischen Y₁ und Y₂ die Funktion des Abschaltpfades zu A ohne Zusatzmaßnahme gewährleistet ist, wenn der L-Pegel dem ausgeschalteten Zustand von IC2 entspricht. Ferner stellt sich bei einem Kurzschluß zwischen Y₁ und Y₂ stets ein gültiger Pegel ein, so daß der Rücklesepfad RL und der Eingang A den gleichen logischen Pegel einlesen. Der Kurzschluß kann durch Rücklesen von Y₁ sicher erkannt werden, wenn Y₁ und Y₂ mit unterschiedlichem logischen Pegel angesteuert werden.

## Patentansprüche

1. Elektrische Schaltungsanordnung zum Erkennen eines Kurzschlusses zwischen Ausgangs-PINs wenigstens eines ICs, welcher jeweils als Ausgangstreiber ein erstes Schaltmittel (Q_{H,1}, Q_{H,2}) und ein zweites Schaltmittel (Q_{L,1}, Q_{L,2}) aufweist,
**dadurch gekennzeichnet,**
**daß** das erste Schaltmittel (Q_{H,1}, Q_{H,2}) und das zweite Schaltmittel (Q_{L,1}, Q_{L,2}) des Ausgangstreibers unterschiedliche Widerstände im eingeschalteten Zustand (R_{DSon}) aufweisen.

2. Elektrische Schaltungsanordnung nach Anspruch 1, **dadurch gekennzeichnet, daß** der wenigstens eine IC als CMOS-IC ausgebildet ist, welcher als Ausgangstreiber einen Highside-Transistor (Q_{H,1}, Q_{H,2}) und einen Lowside-Transistor (Q_{L,1}, Q_{L,2}) aufweist; wobei der Highside-Transistor und der Lowside-Transistor unterschiedliche Source-Drain-Widerstände im eingeschalteten Zustand (R_{DSon}) aufweisen.

3. Schaltungsanordnung nach Anspruch 1 oder 2, **dadurch gekennzeichnet, daß** in dem Ausgangstreiber das zweite Schaltmittel kleiner dimensioniert ist als das erste Schaltmittel.

4. Schaltungsanordnung nach einem der vorstehenden Ansprüche, **dadurch gekennzeichnet, daß** wenigstens einer der Ausgangstreiber mit einem Rücklesepfad ausgebildet ist.
